Europäisches Patentamt

European Patent Office

Office européen des brevets

(19)

(11) Publication number: **0 244 973 B1**

## EUROPEAN PATENT SPECIFICATION

(12)

(45) Date of publication of patent specification: **16.02.94**  (51) Int. Cl.5: **H03F 3/45**

(21) Application number: **87303393.0**

(22) Date of filing: **16.04.87**

(54) **Broadband differential amplifier.**

(30) Priority: **23.04.86 US 855546**

(43) Date of publication of application:
**11.11.87 Bulletin 87/46**

(45) Publication of the grant of the patent:
**16.02.94 Bulletin 94/07**

(84) Designated Contracting States:
**DE FR GB**

(56) References cited:
**EP-A- 0 153 774
US-A- 4 096 398
US-A- 4 393 315**

**IEEE Journal of Solid-State Circuits, Vol. SC-17, no. 3, (1982) Junepages 522-528, New York, U.S.A.; M.G. Degrauwe et al.:"Adaptive Biasing CMOS Amplifiers"**

**Electronic Design, 33 (1985) December, no. 30, page 53E, Hasbrouck Heights, New Yersey, USA; D. Bursky "Double-implanted GaAs process integrates Hall sensor with amplifier"**

(73) Proprietor: **TEXAS INSTRUMENTS INCORPORATED
13500 North Central Expressway
Dallas Texas 75265(US)**

(72) Inventor: **Zimmerman, Dale E.
6037 Frontier Lane
Plano Texas 75023(US)**

(74) Representative: **Abbott, David John et al
Abel & Imray
Northumberland House
303-306 High Holborn
London, WC1V 7LH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 244 973 B1

**Description**

BACKGROUND OF THE INVENTION

1. Field of the Invention.

The present invention relates to semiconductor electronic devices, and, more particularly, to broadband microwave differential amplifiers.

2. Description of the Related Art.

A differential amplifier provides voltage gain to the difference between signals applied to its two input terminals while responding with much lower gain or attenuation to voltages common to the two inputs. Thus desired differential signals are amplified with little effect from extraneous common mode signals. Such extraneous signals frequently arise from signal current flow in long lines or from noise pickup, but they are essentially rejected by the differential amplifier. Further, the differential amplifier provides isolation of input and output quiescent voltage levels by its common mode signal characteristics. Consequently, operational amplifiers, which are basic building blocks for electronic circuits, tyically have differential amplifier input stages. See, generally, J.Graeme and G.Tobey, Eds., Operational Amplifiers: Design and Applications (McGraw-Hill 1972).

The common-mode rejection ratio (CMRR) is a figure of merit for a differential amplifier that compares the gain of signals common to both inputs to the gain of the difference between the signals applied to the inputs. The CMRR is defined as follows: $v_{i1}$ and $v_{i2}$ be small signal voltages applied to inputs 1 and 2, respectively, of a differential amplifier, and $v_{o1}$ and $v_{o2}$ the output voltages at outputs 1 and 2, respectively; then the differential-mode voltage gain is

$$a_d = \frac{v_{o1} - v_{o2}}{v_{i1} - v_{i2}};$$

the common-mode voltage gain is

$$a_c = \frac{v_{o1} + v_{o2}}{v_{i1} + v_{i2}};$$

and the CMRR expressed in dB is

$$\mathrm{CMRR}(dB) = 20 \log \left| \frac{a_d}{a_c} \right|.$$

For a single ended output the same definitions apply but with $v_{o1}$ the output and $v_{o2} = 0$.

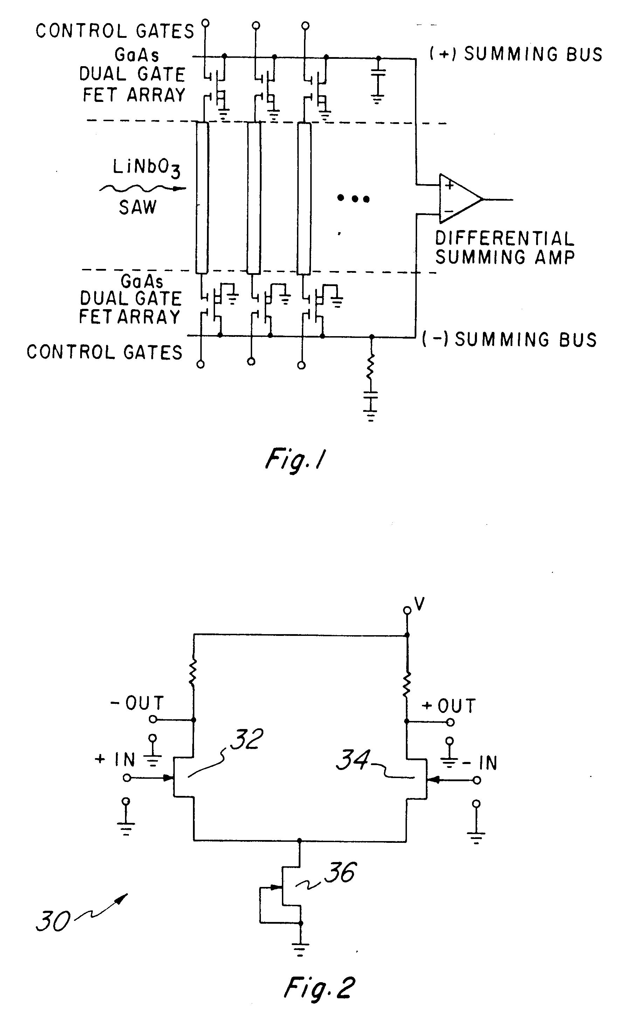

Commerically available operational amplifiers may have a CMRR in the order of 100 dB; however, such operational amplifiers are effectively limited to operation at low frequencies (below about 100 MHz). But many signal processing and instrumentation systems require a broadband high frequency differential amplifier with a large CMRR; typically a low level signal (differential-mode) must be separated from a large interference signal which is common to both inputs (common-mode) at frequencies above 1 GHz. Figure 1 is an example of a signal processing application of a differential amplifier in which the output of a surface acoustic wave (SAW) device is detected at frequencies from 100 MHz to 2 GHz. Such amplifiers are not commercially available, and it is a problem to provide a simple, high frequency, large CMRR broadband differential amplifier.

In EP-A-0 153 774, there is disclosed a GaAs logic element that is compatible with ECL silicon logic and includes a differential long-tailed pair amplifier formed by two GaAs Schottky barrier field effect transistors with a third transistor of the same type forming the tail. The drains of the pair of transistors are connected to resistor loads through diodes to provide voltage translation of the outputs. The amplifier receives a single or parallel input signals and provides upright and inverted output signals.

In IEEE JOURNAL OF SOLID-STATE CIRCUITS, vol. SC-17, No.3, 1982 June, pages 522-528, New York, U.S.A; M. G. DEGRAUWE et al.: "Adaptive Biasing CMOS amplifiers", there is disclosed a transconductance amplifier in which a reference current is fed to the sources of a differentially voltage controlled pair of FETs, the currents from the drains of which are applied via current mirrors and differentially combined to produce a single output current from the amplifier. The reference current is generated so as to be dependent on the output current.

In US-A-4 393 315, there is disclosed a circuit for converting ECL signals to signals suitable for GaAs logic circuits including a long-tailed differential amplifier formed of GaAs FETs with current sources forming the tail and connected to the gates of the differential pair of transistors to provide pull down currents determining the offset voltages set up across diodes through which input signals are applied to the transistor gates.

According to one aspect of the present invention there is provided.

Embodiments of the invention are high frequency, broadband differential amplifiers having large CMRR and simple topology by use of an input differential pair of dual gate field effect transistors with the second gates tied together and with a separate zero-biased field effect transistor as current source for each dual gate FET. The return path for the current sources is through the inputs (as opposed to ground) to avoid the low FET source-drain impedance as a path to ground. The output stages may be single-ended with push-pull FETs to obtain high power and good VSWR. Preferred embodiments are fabricated monolithically on gallium arsenide.

These differential amplifiers solve the problems of large CMRR in a simple topology, broadband amplifier.

a differential amplifier, comprising:

first and second field effect transistors, the sources of said transistors electrically connected;

first and second inputs electrically connected to the gates of said first and second transistors, respectively;

first and second outputs connected to the drains of said first and second transistors, respectively;

a first current source electrically directly connected from the source of said first transistor to said first input;

a second current source electrically directly connected from the source of said second transistor to said second input.

According to another aspect of the present invention there is provided a broadband differential amplifier, comprising:

first and second input terminals, each of said terminals with a predetermined first dc potential;

an output terminal;

a first differential amplifying circuit including first and second MESFETs, the gates of said first and second MESFETs connected through level shifters to said first and second input terminals, respectively, and the sources of said MESFETs connected together;

a load circuit for said MESFETs and connected to said output terminal;

a first current source directly connected between the source of said first MESFET and said first input;

a second current source directly connected between the source of said second MESFET and said second input.

BRIEF DESCRIPTION OF THE DRAWINGS

The drawings are schematic for clarity.
FIG.1 is a schematic diagram of a broadband differential amplifier application;
FIG.2 is a schematic diagram of a typical differential pair;
FIG.3 is a simplified small signal equivalent circuit for the differential pair of FIG.1;
FIG.4 illustrates a small-signal equivalent circuit for a microwave FET;
FIG.5 illustrates connections for the differential pair of FIG. 1;
FIG.6 is a schematic diagram of a first preferred embodiment differential pair;
FIG.7 is a simplified small signal equivalent circuit for the first preferred embodiment;
FIG.8 is a schematic diagram of a second preferred embodiment differential pair;
FIG.9 illustrates a small-signal equivalent circuit for a microwave dual-gate FET;
FIG.10 is a simplified schematic diagram for the second preferred embodiment;
FIG.11 is a layout for the second preferred embodiment;

FIG.12 compares the CMRR for the first and second preferred embodiments;

FIGS.13A-B are simulations for the differential and common mode gains for the second preferred embodiment;

FIG.14 is a schematic for a preferred embodiment push-pull differential amplifier;

FIG.15 is a simplified small-signal equivalent circuit for the push-pull amplifier;

FIG.16 are simulations for the differential and common mode gains for the push-pull amplifier; and

FIG.17 are simulations for the second preferred embodiment cascaded with the push-pull amplifier.

DESCRIPTION OF THE PREFERRED EMBODIMENTS

A differential amplifier or operational amplifier input stage is typically a pair of transistors (one for each of the inputs) biased into the active region and tied together to share a common current. Figure 2 illustrates a pair of field effect transistors (FETs) 32, 34 with their sources tied together to form a differential pair, generally denoted 30, and with zero-biased FET 36 providing the sum of the source-drain currents of FETs 32, 34. The use of FETs instead of the bipolar transistors typically found in commerical operational amplifiers is in preparation for discussion of the preferred embodiments which use gallium arsenide FETs monolithically integrated for high frequency operation. In particular, microwave FETs are typically gallium arsenide MESFETs with gates 1-2 $\mu$m long and hundreds of $\mu$m wide to provide sufficient transconductance.

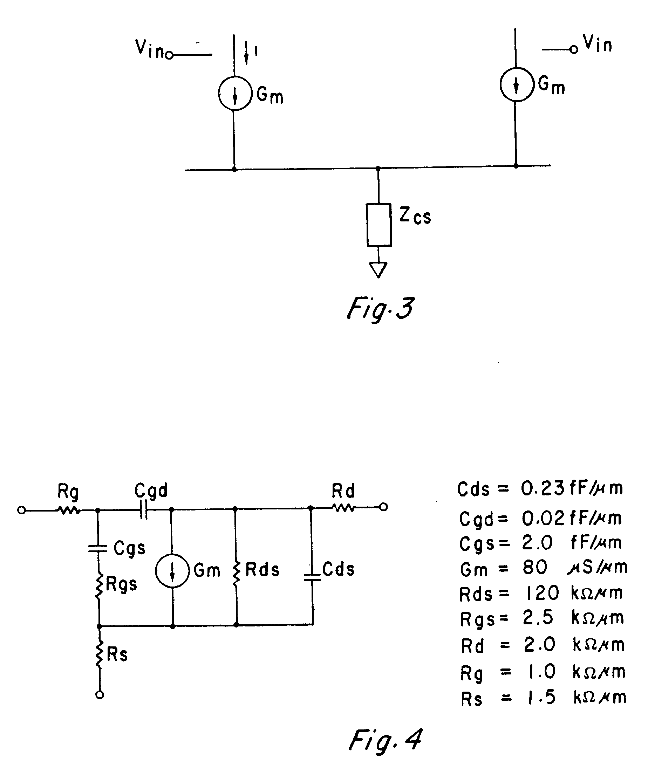

The CMRR of stage 30 can be approximated for low frequencies (< 100 MHz) from the simplified small-signal equivalent circuit shown in Figure 3 in which $G_m$ is the transconductance of each of FETs 32, 34 and $Z_{cs}$ is the small signal impedance of the current source FET 36. The result is

$$\mathrm{CMRR}(dB) = 20\log\frac{1 + 2G_m Z_{cs}}{2}$$

The low drain-source impedance of FET 36 provides a low impedance $Z_{cs}$ to ground and limits the CMRR to about 16dB for typical values of $G_m$ and $Z_{cs}$ such as 10 mS and 600 $\Omega$, respectively. Note that typical values of gallium arsenide microwave FET parameters are shown in Figure 4 as a function of gate width in $\mu$m.

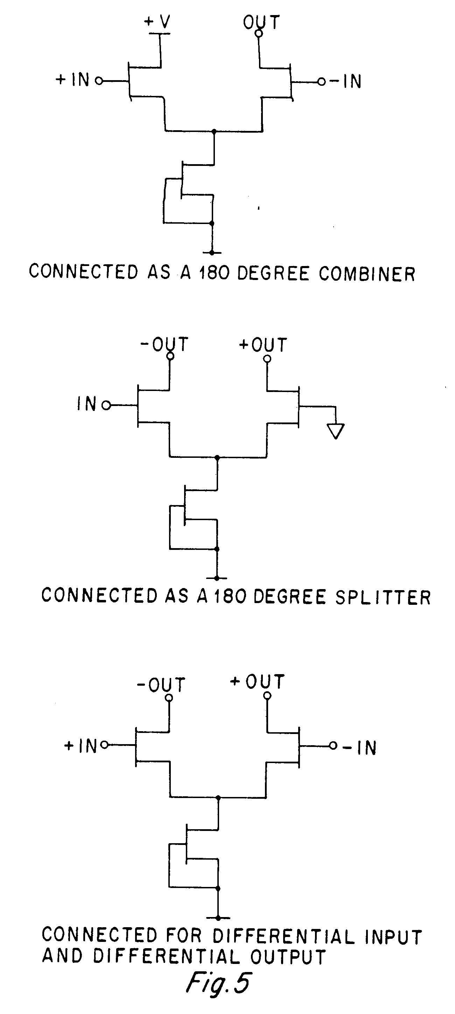

Figure 5 illustrates some of the various connections for applications of a differential pair. Note that the differential pair may be connected as a 180 degree combiner, 180 degree splitter, or differential input/differential output amplifier as illustrated.

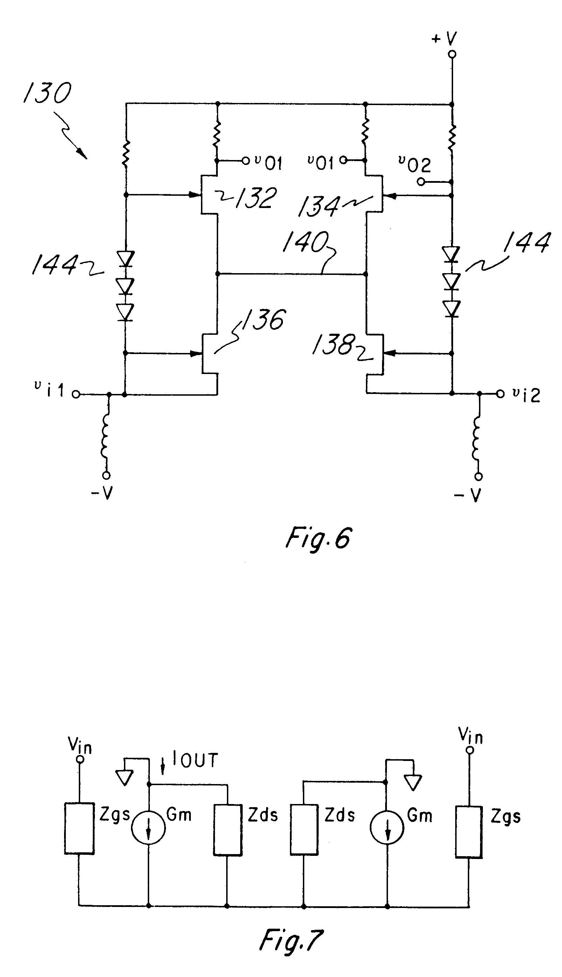

A first preferred embodiment differential pair input stage, generally denoted 130 and illustrated in Figure 6, avoids the low impedance to ground of current source 36 by using a separate current source for each FET of the differential pair and having the current sources terminate at the inputs. In particular, the differential pair is the pair of $n$-channel FETs 132, 134, and FET 132 has zero-biased $n$-channel FET 136 as current source, and FET 134 has zero-biased $n$-channel FET 138 as current source. The gate width of FETs 132, 134 is about three times the gate width of FETs 136, 138 which are biased at $I_{DSS}$; thus FETs 132, 134 are biased to about 33% of $I_{DSS}$. Diodes 142 and 144 shift the level of the quiescent gate voltage on FETs 132, 134 so that $V_{DS}$ of current source FETs 136, 138 leads to good current regulation. Connection 140 ties the two current sources 136, 138 together at their drains, so the differential pair FETs 132, 134 are still splitting a common source current. The inputs are at the sources of current source FETs 136, 138 and the negative voltage supply; thus there is no direct path to ground through $Z_{cs}$.

Approximation of the CMRR for stage 130 by calculation with the simplified small-signal equivalent circuit shown in Figure 7 yields:

$$\mathrm{CMRR}(dB) = 20\log\frac{G_m(Z_{ds} + Z_{gs}) + G_m^2 Z_{ds} Z_{gs}}{2}$$

where $G_m$ is the transconductance of each of FETs 132, 134; $Z_{ds}$ is the drain-source impedance of each of FETs 132, 134; and $Z_{gs}$ is $Z_{cs}$ parallel $C_{gs}$ with $Z_{cs}$ the drain-source impedance of each of FETs 136, 138 and $C_{gs}$ the gate-source capacitance of each of FETs 132, 134, Thus CMRR is about 30 dB for FET parameters similar to those yielding 16 dB for stage 30. But it is apparent that parasitics internal to the

4

differential pair 132, 134, such as the drain-source impedance, also limit the CMRR.

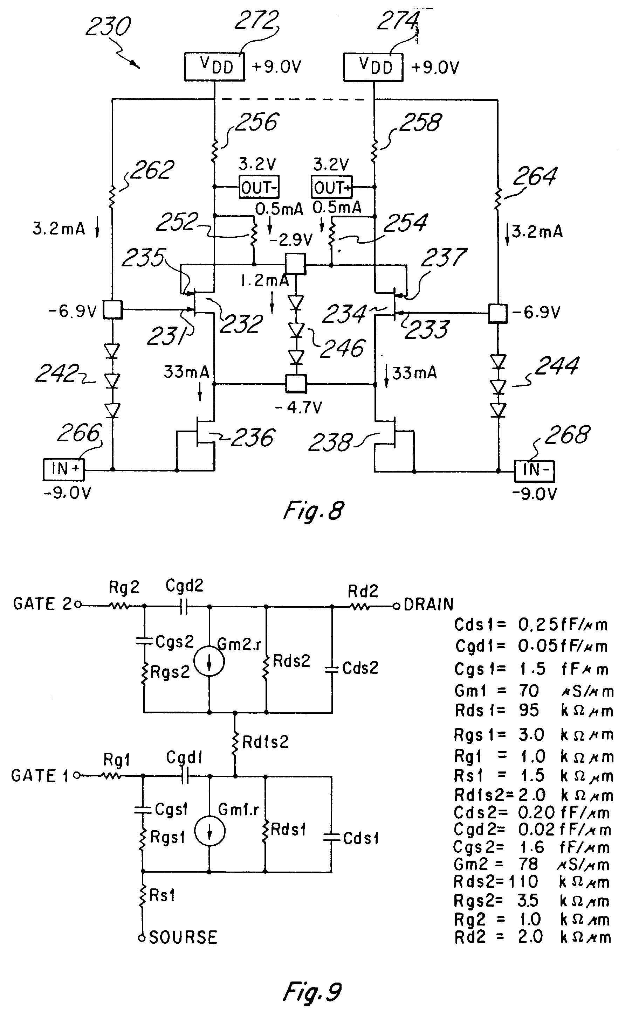

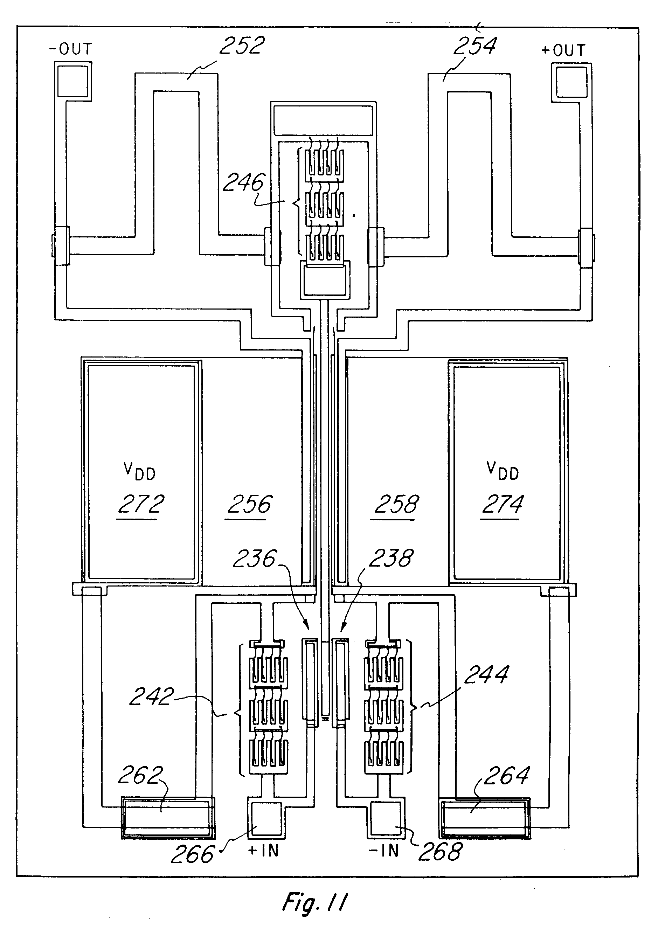

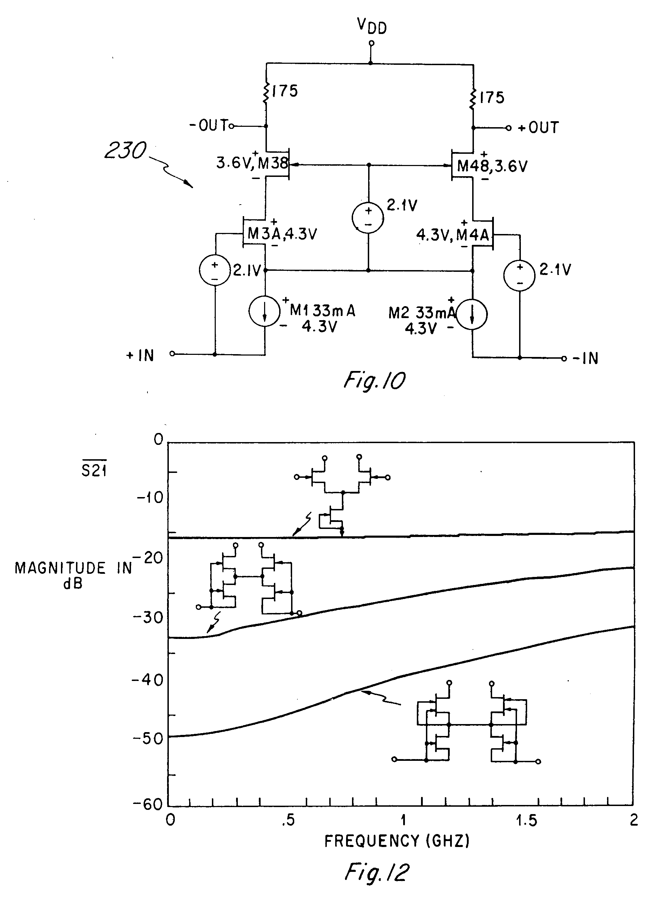

A second preferred embodiment differential pair input stage, generally denoted 230 and illustrated in Figure 8, overcomes the drag on CMRR from the drain-source impedance of the differential pair FETs 132, 134 of stage 130 by use of dual gate FETs for the differential pair FETs with the second gates tied together. Note that the drain-source impedance of a dual gate FET is related to the drain-source impedance of a single gate FET by:

$$Z_{ds}(dualgate) \approx (G_m R_{ds} + 1)R_{ds}, \text{ and}$$
$$Z_{ds}(singlegate) \approx R_{ds},$$

so using the values of the parameters in Figure 4 shows that the dual gate drain-source impedance is about ten times the single gate drain-source impedance. In stage 230 FETs 232, 234 are dual gate MESFETs fabricated in gallium arsenide with 1.5 $\mu$m long and 300 $\mu$m wide gates with the gates separated by 2 $\mu$m; Figure 9 is a small-signal equivalent circuit for FETs 232, 234 modeled as two single gate FETs cascode connected and with the parameters expressed as functions of the gate width. The stage 230 also includes gallium arsenide MESFETs 236, 238 with 1.5 $\mu$m long and 100 $\mu$m wide gates with the gates connected to the sources so that these FETs act as current sources for FETs 232, 234; diode stacks 242, 244 each of three diodes which shift the level at first gates 231, 233 of FETs 232, 234, respectively, up 2.1 V relative to the sources of FETs 236, 238; diode stack 246 of three diodes which shifts the level of second gates 235, 237 of FETs 232, 234, respectively, relative to the sources of the FETS by 2.1 V; 10 k$\Omega$ bias resistors 252, 254; 175 $\Omega$ load resistors 256, 258; 5 k$\Omega$ bias resistors 262, 264; 9.0 V power supplies 272, 274; and -9.0 V power supplies 266, 268. The two inputs are at power supplies 266, 268, and the two outputs are between load resistors 256, 258 and the drains of FETs 232, 234. The diodes in the stacks 242, 244, 246 all have anodes of 100 $\mu$m by 1.5 $\mu$m.

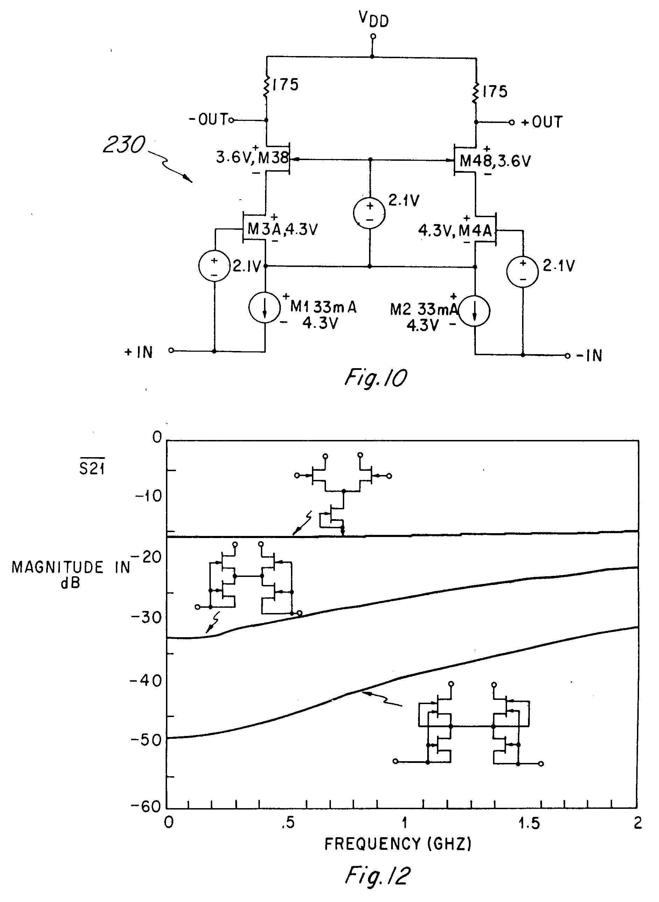

Figure 10 is a simplified schematic diagram of stage 230; and Figure 11 a layout for stage 230. The quiescent voltages and currents are as indicated in Figure 10; current source FETs 236, 238 each operate at $I_{DSS}$, which equals 33 mA, and thereby biases differential FETs 232, 234 to operate at 33% of $I_{DSS}$ because the gates of FETs 232, 234 are three times as wide as the gates of FETs 236, 238. Diode stacks 242, 244 raise the $V_{DS}$ of current source FETs 236, 238 to about 4.3 V (because $V_{G1S}$ for FETs 232, 234 equals -2.2 V for $I_{DS} = 33\%I_{DSS}$) which insures good current source operation. Diode stack 246 raises the $V_{G2S}$ to about 2.1 V to maximize $Z_{ds}$ of the dual-gate FETs 232, 234.

Stage 230 may be fabricated monolithically on semi-insulating (chromium doped) GaAs as follows. First, the active areas are formed by ion implantation with silicon to a concentration of $2 \times 10^{17}/cm^3$ to a depth of 0.4 $\mu$m. Next, the active areas are isolated as mesas, and Ti/Pt/Au deposited. The FET gates and diode anodes are defined in the Ti/Pt/Au by optical lithography and formed by plasma etching. Note that the resistivity of the active area is about $10^{-2}\Omega$cm, so the sheet resistance is about 400 $\Omega/\square$ and the bias resistors may be meanders in the active area; see Figure 11. Ohmic contacts are formed by liftoff of gold/germanium/nickel; and passivation is by plasma deposition of $Si_3N_4$.

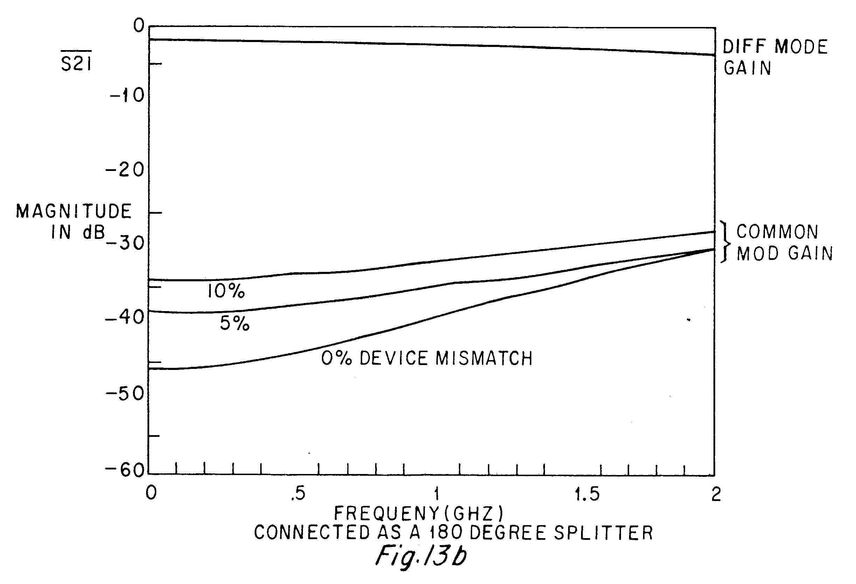

Figure 12 are simulations that compare the CMRR of differential pair stages 30, 130, and 230 up to 2 GHz. For the simulations, the outputs were presumed connected to microstrip transmission lines with characteristic impedances of 50 $\Omega$ and matched loads and the inputs were presumed to have generator impedances of 50 $\Omega$. Figure 13A shows the differential mode and common mode gain up to 2 GHz and for mismatches of 0%, 5%; and 10% of FETs 232, 234 for stage 230 connected as a 180 degree combiner; and Figure 13B shows the same data for connection as a 180 degree splitter. The relative insensitivity of the CMRR to device mismatch is apparent. The curves of Figures 12 and 13A-B are simulations based on the equivalent circuits of Figures 4 and 9. Note that at low frequencies (< 100 MHz) the -9.0 V power supplies (which supply current through an inductor) may provide a low impedance to ground, so the corresponding portion of Figures 12 and 13A-B would be modified.

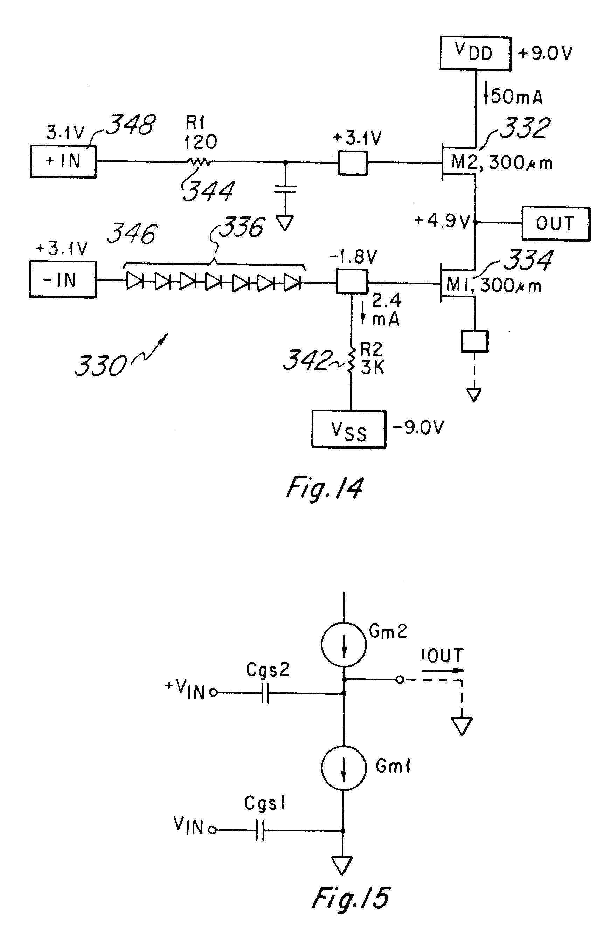

Figure 14 is a schematic diagram of a push-pull differential amplifier, generally denoted 330, with single-ended output, and Figure 15 is a simplified small-signal equivalent circuit for amplifier 330. Amplifier 330 is fabricated in gallium arsenide analogous to stages 130 and 230 and includes FETs 332, 334 with 1.5 $\mu$m long and 300 $\mu$m wide gates, diode stack 336 of seven diodes with anodes 1.5 $\mu$m by 300 $\mu$m, 3 k$\Omega$ resistor 342, and 120 $\Omega$ resistor 344. Diodes 336 shift the inverting input 346 to the same quiescent level as the noninverting input 348; namely 3.1 V. The quiescent output level is 4.9 V. The CMRR calculated from Figure 15 is

$$\mathrm{CMRR}(dB) \approx -10\log \left| \frac{\Delta G_m}{G_m}^2 + \frac{F}{F_t} \right|$$

where $\Delta G_m = G_{m2}\text{-}G_{m1}$,

$$G_m = \frac{G_{m2}+G_{m1}}{2},$$

and

$$F_t = \frac{G_m}{2\pi C_{gs2}}.$$

Thus with perfectly matched devices, the CMRR at zero frequency is infinite; however, small device mismatch significantly degrades CMRR. For example, a 10% mismatch in transconductance leads to a CMRR of 20 dB. High frequency CMRR is limited by current fed through $C_{gs2}$ and gives rise to the

$$\frac{F}{F_t}$$

term. For example, at a frequency of 10% of $F_t$ (typically about 1 GHz), CMRR is about 20 dB.

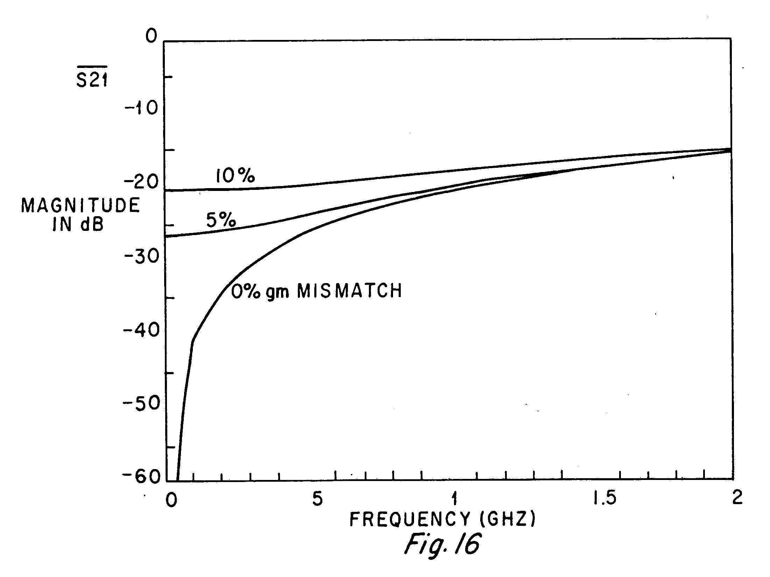

Figure 16 shows a simulation for amplifier 330 CMRR based on the FET small-signal equivalent circuit of Figure 4 with 300 $\mu$m wide and 1.5 $\mu$m long gates and seven diodes 336 with anodes 100 $\mu$m by 1.5 $\mu$m and drawing 2.4 mA bias current. For the simulations the output was presumed connected to a microstrip transmission line with 50 $\Omega$ characteristic impedance and terminated by a matched load, and the inputs were similarly presumed from a generator with 50 $\Omega$ impedance; note that the inputs also are 3.1 V power supplies which have large chokes to prevent a-c shorting to ground. Simulations also indicate output VSWR for amplifier 330 is less than 2:1 up to 2 GHz and power output is about 20 dBm at 1 dB compression.

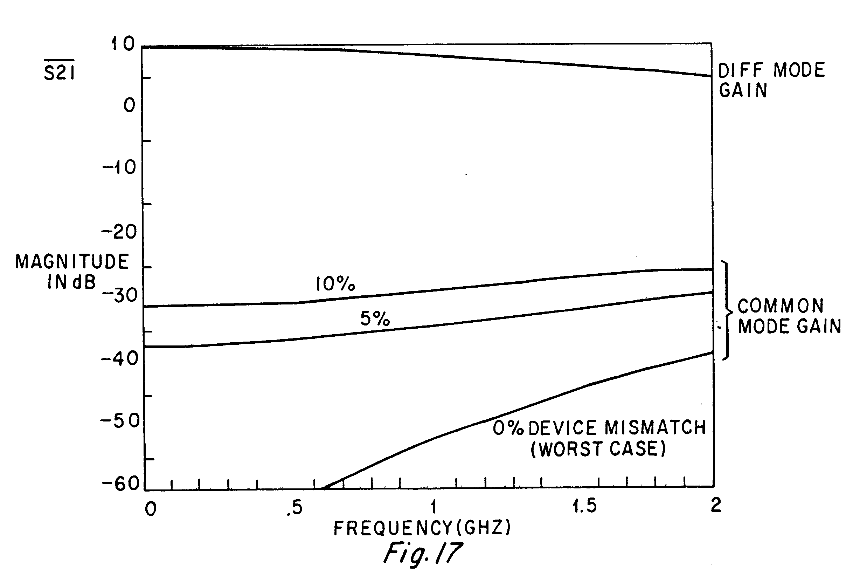

Differential pair input stage 230 can be directly cascaded with push-pull amplifier 330 and the resulting two stage amplifier has about 10 dB differential-mode gain (note that the outputs of stage 230 are loaded by push-pull 330 inputs and not 50 $\Omega$) and CMRR of at least 35 dB even for 10% device mismatch. Figure 17 shows simulation results for the cascaded amplifier and indicates the dependence of CMRR on mismatch.

MODIFICATIONS AND ADVANTAGES

Various modifications of the preferred embodiment amplifiers may be made while retaining the separate current sources coupled to the differential inputs feature of the amplifiers. For example, the dimensions and shapes of the FETs can be varied such as shorter and wider gates; the materials can be varied such as silicon instead of gallium arsenide substrate and aluminum instead of titanium/platinum/gold gates and anodes; the FETs can be replaced in whole or in part by bipolar or even heterojunction bipolar transistors; the push-pull output stage can be replaced by a differential output stage; and differential amplifier stages can be inserted between the differential input and the output stage to increase the overall gain. For higher frequency operation, the separate current sources could be inductors; such inductors could be fabricated as microstrip transmission lines on a gallium arsenide substrate.

The advantages of the present invention include a simple topology for a broadband, high CMRR differential amplifier.

**Claims**

1.  A differential amplifier, comprising:
    first and second field effect transistors (232, 234), the sources of said transistors electrically connected;
    first and second inputs (266, 268) electrically connected to the gates of said first and second transistors, respectively;
    first and second outputs (OUT-, OUT+) connected to the drains of said first and second transistors, respectively;

characterized by:

a first current source (236) electrically directly connected from the source of said first transistor to said first inputs (266);

a second current source (238) electrically directly connected from the source of said second transistor to said second input (268).

2. The amplifier of claim 1, further comprising:

level shifting diodes (242, 244) between said first input (266) and said first transistor gate (231) and between said second input (268) and said second transistor gate (233).

3. The amplifier of claim 2, wherein:

said current sources (236, 238) are zero-biased field effect transistors.

4. The amplifier of claim 2, wherein:

said current sources (236, 238) are inductors.

5. The amplifier of claim 1, wherein:

said first and second field effect transistors (232, 234) are both dual gate field effect transistors with the second gate of said first field effect transistor (235) connected to the second gate of said second field effect transistor (237).

6. The amplifier of claim 1, wherein:

said field effect transistors (232, 234) are all MESFETs with gallium arsenide semiconductor.

7. The amplifier of claim 1, further comprising:

a push-pull single-ended output stage (330) with inputs connected to said first and second outputs.

8. The amplifier of claim 7, wherein:

said push-pull stage (330) includes third and fourth field effect transistors (332 334) connected in series and with at least one of the gates of said third and fourth transistors level shifted to form said stage inputs.

9. A broadband differential amplifier, comprising:

first and second input terminals (266, 268), each of said terminals with a predetermined first dc potential;

an output terminal (OUT-);

a first differential amplifying circuit including first and second MESFETs (232, 234), the gates of said first and second MESFETs connected through level shifters (242, 244) to said first and second input terminals (266, 268), respectively, and the sources of said MESFETs connected together;

a load circuit (256, 258) for said MESFETs and connected to said output terminal (OUT-);

characterized by :

a first current source (236) directly connected between the source of said first MESFET and said first input (266);

a second current source (238) directly connected between the source of said second MESFET and said second input (268).

10. The amplifier of claim 9, wherein:

said load circuit includes third and fourth MESFETs (332, 334) push-pull connected; with the gates of said third and fourth MESFETs connected through at least one level shifter (336) to the drains of said first and second MESFETs, respectively.

11. The amplifier of claim 10, wherein:

said first and second MESFETs (232, 234) are each dual gate MESFETs with the second gates connected together and connected through a level shifter to the sources of said first and second MESFETs.

12. The amplifier of claim 10, wherein:

said MESFETs, load circuit, and level shifters are made of gallium arsenide and metal.

7

**Patentansprüche**

1. Ein Differenzverstärker, mit:

    einem ersten und einem zweiten Feldeffekttransistor (232, 234), wobei die Sources dieser Transistoren elektrisch verbunden sind;

    einem ersten und einem zweiten Eingang (266, 268), die mit den Gates des ersten bzw. des zweiten Transistors verbunden sind;

    einem ersten und einem zweiten Ausgang (OUT-, OUT+), die mit den Drains des ersten bzw. des zweiten Transistors verbunden sind;

    gekennzeichnet durch:

    eine erste Stromquelle (236), die elektrisch direkt zwischen die Source des ersten Transistors und den ersten Eingang (266) geschaltet ist;

    eine zweite Stromquelle (238), die elektrisch direkt zwischen die Source des zweiten Transistors und den zweiten Eingang (268) geschaltet ist.

2. Der Verstärker von Anspruch 1, der ferner umfaßt:

    Pegelverschiebungsdioden (242, 244) zwischen dem ersten Eingang (266) und dem Gate (231) des ersten Transistors sowie zwischen dem zweiten Eingang (268) und dem Gate (233) des zweiten Transistors.

3. Der Verstärker von Anspruch 2, bei dem:

    die Stromquellen (236, 238) Nullvorspannungs-Feldeffektransistoren sind.

4. Der Verstärker von Anspruch 2, bei dem:

    die Stromquellen (236, 238) Drosselspulen sind.

5. Der Verstärker von Anspruch 1, bei dem:

    sowohl der erste als auch der zweite Feldeffekttransistor (232, 234) ein Doppelgate-Feldeffekttransistor ist, wobei das zweite Gate des ersten Feldeffekttransistors (235) mit dem zweiten Gate des zweiten Feldeffekttransistors (237) verbunden ist.

6. Der Verstärker von Anspruch 1, bei dem:

    sämtliche Feldeffekttransistoren (232, 234) MESFETs mit Galliumarsenidhalbleiter sind.

7. Der Verstärker von Anspruch 1, der ferner umfaßt:

    eine Gegentaktusgangsstufe (330) mit Eintaktausgang, deren Eingänge mit dem ersten und mit dem zweiten Ausgang verbunden sind.

8. Der Verstärker von Anspruch 7, bei dem:

    die Gegentaktstufe (330) einen dritten und einen vierten Feldeffekttransistor (332, 334) enthält, die in Reihe geschaltet sind, wobei der Pegel wenigstens eines der Gates des dritten und des vierten Transistors verschoben ist, um die Stufeneingänge zu bilden.

9. Ein Breitband-Differenzverstärker, mit:

    einem ersten und einem zweiten Eingangsanschluß (266, 268), wovon jeder auf einem vorgegebenen ersten Gleichspannungspotential liegt;

    einem Ausgangsanschluß (OUT-);

    einer ersten Differenzverstärkerschaltung, die einen ersten und einen zweiten MESFET (232, 234) enthält, wobei die Gates des ersten und des zweiten MESFET über Pegelschieber (242, 244) mit dem ersten bzw. dem zweiten Eingangsanschluß (266, 268) verbunden sind und die Sources der MESFETs miteinander verbunden sind;

    einer Lastschaltung (256, 258) für die MESFETs, die mit dem Ausgangsanschluß (OUT-) verbunden ist;

    gekennzeichnet durch:

    eine erste Stromquelle (236), die direkt zwischen die Source des ersten MESFET und den ersten Eingang (266) geschaltet ist;

    eine zweite Stromquelle (238), die direkt zwischen die Source des zweiten MESFET und den zweiten Eingang (268) geschaltet ist.

**10.** Der Verstärker von Anspruch 9, bei dem:

die Lastschaltung einen dritten und einen vierten MESFET (332, 334) enthält, die im Gegentakt gekoppelt sind; wobei die Gates des dritten und des vierten MESFET über wenigstens einen Pegelschieber (336) mit den Drains des ersten bzw. des zweiten MESFET verbunden sind.

**11.** Der Verstärker von Anspruch 10, bei dem:

der erste und der zweite MESFET (232, 234) jeweils ein Doppelgate-MESFET ist, wobei die zweiten Gates miteinander und über einen Pegelschieber mit den Sources des ersten und des zweiten MESFET verbunden sind.

**12.** Der Verstärker von Anspruch 10, bei dem:

die MESFETs, die Lastschaltung und die Pegelschieber aus Galliumarsenid und aus Metall hergestellt sind.

**Revendications**

**1.** Amplificateur différentiel comprenant : des premier et second transistors à effet de champ (232, 234), les sources desdits transistors étant électriquement connectées ;

des première et seconde entrées (266, 268) électriquement connectées respectivement aux grilles desdits premier et second transistors ;

des première et seconde sorties (OUT-, OUT +) connectées respectivement aux drains desdits premier et second transistors ;

caractérisé par :

une première source de courant (236) directement connectée électriquement à partir de la source dudit premier transistor à ladite première entrée (266);

une seconde source de courant (238) directement connectée électriquement à partir de la source dudit second transistor à ladite seconde entrée (268) .

**2.** Amplificateur selon la revendication 1 comprenant , de plus :

des diodes de décalage de niveau (242, 244) entre ladite première entrée (266) et ladite grille (231) du premier transistor et entre ladite seconde entrée (268) et ladite grille (233) du second transistor.

**3.** Amplificateur selon la revendication 2 dans lequel :

lesdites sources de courant (236, 238) sont des transistors à effet de champ à polarisation nulle.

**4.** Amplificateur selon la revendication 2 dans lequel :

lesdites sources de courant (236, 238) sont des inductances.

**5.** Amplificateur selon la revendication 1 dans lequel :

lesdits premier et second transistors à effet de champ (232, 234) sont deux transistors à effet de champ à double grille avec la seconde grille dudit premier transistor à effet de champ (235) connectée à la seconde grille dudit second transistor à effet de champ (237).

**6.** Amplificateur selon la revendication 1 dans lequel :

lesdits transistors à effet de champ (232, 234) sont tous des MESFET (transistor à effet de champ métal-semiconducteur) avec un semiconducteur d'arséniure de gallium.

**7.** Amplificateur selon la revendication 1 comprenant, de plus :

un étage de sortie symétrique à sortie simple (330) avec des entrées connectées auxdites première et seconde sorties.

**8.** Amplificateur selon la revendication 7 dans lequel :

ledit étage symétrique (330) inclut des troisième et quatrième transistors à effet de champ (332, 334) connectés en série et ayant au moins une des grilles desdits troisième et quatrième transistors décalée en niveau pour former lesdites entrées de l'étage.

**9.** Amplificateur différentiel à large bande comprenant :

des première et seconde bornes d'entrée (266, 268) , chacune desdites bornes ayant un premier potentiel continu prédéterminé ;

une borne de sortie (OUT-) ;

un premier circuit d'amplification différentielle incluant des premier et second transistors MESFET (232, 234), les grilles desdits premier et second transistors MESFET étant connectées respectivement à travers des dispositifs de décalage de niveau (242, 244), auxdites première et seconde bornes d'entrée (266, 268) et les sources desdits transistors MESFET étant connectées ensemble ;

un circuit de charge (256, 258) pour lesdits transistors MESFET et connecté à ladite borne de sortie (OUT-) ;

caractérisé par :

une première source de courant (236) connectée directement entre la source dudit premier transistor MESFET et ladite première entrée (266) ;

une seconde source de courant (238) connectée directement entre la source dudit second transistor MESFET et ladite seconde entrée (268) .

10. Amplificateur selon la revendication 9 dans lequel :

ledit circuit de charge comprend les troisième et quatrième transistors MESFET (332, 334) connectés en montage symétrique ; les grilles desdits troisième et quatrième transistors MESFET étant connectées , respectivement, à travers au moins un décaleur de niveau (336) , aux drains desdits premier et second transistors MESFET.

11. Amplificateur selon la revendication 10 dans lequel :

lesdits premier et second transistors MESFET (232, 234) sont chacun des MESFET à double grille avec des secondes grilles connectées ensemble et connectées à travers un dispositif de décalage de niveau aux sources desdits premier et second transistors MESFET.

12. Amplificateur selon la revendication 10 dans lequel :

ledit circuit de charge des transistors MESFET et les dispositifs de décalage de niveau sont réalisés en arséniure de gallium et en métal.

Fig. 1

Fig. 2

Fig. 3

$$Cds = 0.23\,fF/\mu m$$
$$Cgd = 0.02\,fF/\mu m$$
$$Cgs = 2.0\;\;fF/\mu m$$
$$Gm = 80\;\;\mu S/\mu m$$
$$Rds = 120\;\;k\Omega/\mu m$$
$$Rgs = 2.5\;\;k\Omega/\mu m$$
$$Rd = 2.0\;\;k\Omega/\mu m$$
$$Rg = 1.0\;\;k\Omega/\mu m$$
$$Rs = 1.5\;\;k\Omega/\mu m$$

Fig. 4

CONNECTED AS A 180 DEGREE COMBINER

CONNECTED AS A 180 DEGREE SPLITTER

CONNECTED FOR DIFFERENTIAL INPUT
AND DIFFERENTIAL OUTPUT

*Fig.5*

130

+V

Fig.6

Fig.7

**Fig.8**

$Cds1= 0.25 fF/\mu m$
$Cgd1= 0.05 fF/\mu m$
$Cgs1= 1.5\ fF/\mu m$
$Gm1 = 70\ \mu S/\mu m$
$Rds1= 95\ k\Omega \mu m$

$Rgs1= 3.0\ k\Omega \mu m$
$Rg1 = 1.0\ k\Omega \mu m$
$Rs1 = 1.5\ k\Omega \mu m$
$Rd1s2= 2.0\ k\Omega \mu m$
$Cds2= 0.20 fF/\mu m$
$Cgd2= 0.02 fF/\mu m$
$Cgs2= 1.6\ fF/\mu m$
$Gm2 = 78\ \mu S/\mu m$
$Rds2= 110\ k\Omega \mu m$
$Rgs2= 3.5\ k\Omega \mu m$
$Rg2 = 1.0\ k\Omega \mu m$
$Rd2 = 2.0\ k\Omega \mu m$

**Fig.9**

15

EP 0 244 973 B1

Fig. 11

16

Fig. 10

Fig. 12

17

*Fig.10*

*Fig.12*

18

Fig.13b

DIFF MODE GAIN

COMMON MOD GAIN

S21

MAGNITUDE IN dB

0% DEVICE MISMATCH

10%

5%

FREQUENY(GHZ)
CONNECTED AS A 180 DEGREE SPLITTER

Fig.14

Fig.15

20

Fig. 16

Fig. 17